# EUROPEAN PATENT APPLICATION

(11) **EP 4 733 116 A1**
(43) Date of publication of application: **29.04.2026**
(21) Application number: 25204379.9
(22) Date of filing: 24.09.2025
(51) Int. Cl.: B60L 1/00, B60L 3/04, B60L 53/22

(54) **CONTROLLER, CHARGING SYSTEM, AND VEHICLE**

(30) Priority: 16.10.2024 JP 2024180992
(71) Applicant: TOYOTA JIDOSHA KABUSHIKI KAISHA, Toyota-shi, Aichi-ken 471-8571 (JP)
(72) Inventor: WATANABE, Yu, Aichi-ken, 471-8571 (JP)
(74) Representative: D Young & Co LLP

(57) **Abstract**

A controller (50) conducts a first inspection and a second inspection. In the first inspection, the controller (50) controls a switching device (120) such that, during application of a voltage between a first power line (PL2b) and a second power line (PL2a) constituting a first power path (PL2), the first power line (PL2b) is electrically connected to a power storage device (30) and the second power line (PL2a) is disconnected from the power storage device (30), and determines whether or not the switching device (120) is faulty. In the second inspection, the controller (50) controls the switching device (120) such that the second power line (PL2a) is electrically connected to the power storage device (30) and the first power line (PL2b) is disconnected from the power storage device (30), and determines whether or not the switching device (120) is faulty.

## Description

### CROSS REFERENCE TO RELATED APPLICATIONS

This nonprovisional application is based on Japanese Patent Application No. 2024-180992 filed on October 16, 2024, with the Japan Patent Office, the entire contents of which are hereby incorporated by reference.

### BACKGROUND

### Field

The present disclosure relates to a controller, a charging system, and a vehicle.

### Description of the Background Art

Japanese Patent Laying-Open No. 2021-112017 discloses a charging system including: a bi-directional charger; an inlet; a vehicle interior outlet; and a C contact relay that switches between a first power path on the inlet side and a second power path on the vehicle interior outlet side. The charging system conducts an inspection of the C contact relay. In this inspection, the C contact relay and the bi-directional charger are controlled such that the C contact relay connects the bi-directional charger to the vehicle interior outlet and the bi-directional charger outputs a voltage less than 100 V to the vehicle interior outlet. When the voltage is detected at the inlet, the C contact relay is determined as being welded. When the voltage is not detected at the inlet, the C contact relay is determined as being normal. The bi-directional charger disclosed in Japanese Patent Laying-Open No. 2021-112017 functions as a bi-directional power converter.

### SUMMARY

In the inspection method disclosed in Japanese Patent Laying-Open No. 2021-112017, the bi-directional power converter outputs a voltage for inspection of the C contact relay. While the C contact relay is normal, a voltage is applied to the vehicle interior outlet and the second power path in each inspection. Such a voltage application may accelerate deterioration of the vehicle interior outlet and the second power path.

The present disclosure has been made to solve the above-described problem, and an object thereof is to accurately grasp the state of a charging system (for example, whether or not a function of switching power paths is faulty) while suppressing deterioration of the charging system resulting from an inspection.

According to a first aspect of the present disclosure, a controller described below is provided.

(Clause 1) The controller controls a charger configured to be electrically connectable to each of a first power path, a second power path, and a power storage device. The charger includes a switching device configured to electrically connect one of the first power path and the second power path to the power storage device. The controller is configured to control the charger to charge the power storage device with electric power supplied from the first power path while the power storage device and the first power path are electrically connected via the charger. The controller is configured to control the charger to supply electric power to the second power path using electric power supplied from the power storage device while the power storage device and the second power path are electrically connected via the charger. The controller is configured to conduct a first inspection and a second inspection. The first inspection includes: controlling the switching device such that, during application of a voltage between a first power line and a second power line constituting the first power path, the first power line is electrically connected to the power storage device and the second power line is disconnected from the power storage device; and determining whether or not the switching device is faulty based on a voltage applied on a side on which the power storage device is located with respect to the switching device. The second inspection includes: in response to a determination in the first inspection that the switching device is not faulty, controlling the switching device such that the second power line is electrically connected to the power storage device and the first power line is disconnected from the power storage device; and determining whether or not the switching device is faulty based on the voltage applied on the side on which the power storage device is located with respect to the switching device.

As described above, in each of the first and second inspections, the controller controls the switching device to disconnect one of the first and second power lines constituting the first power path from the power storage device. Thus, if the switching device normally operates, the voltage through the first power path is not applied on the side on which the power storage device is located with respect to the switching device. Therefore, deterioration of the charging system resulting from an inspection is suppressed. Further, deterioration of the charging system resulting from an inspection is thus suppressed to thereby facilitate highly frequent inspections.

On the other hand, in each of the first and second inspections, when the voltage through the first power path is applied on the side on which the power storage device is located with respect to the switching device, the switching device is regarded as not normally operating. Thus, according to the controller, the state of the charging system (in particular, whether or not the switching device is faulty) can be accurately grasped. Further, the controller conducts the first and second inspections to make it possible to check whether or not the switching device can be correctly controlled for two operation patterns of the switching device.

According to a second aspect of the present disclosure, a charging system described below is provided.

(Clause 2) The charging system includes the controller described in Clause 1 and a charger configured to be controlled by the controller. The charger further includes: a power conversion circuit located between the switching device and the power storage device; and a first voltage sensor configured to detect a first voltage applied between the switching device and the power conversion circuit. The power conversion circuit is configured to convert DC power supplied from the power storage device into AC power and output the AC power to the switching device. The power conversion circuit is configured to convert AC power supplied from the first power path into DC power and output the DC power to the power storage device. The first voltage sensor is configured to output a detection value of the first voltage to the controller.

According to the above-described configuration, the charging system easily charges the power storage device with alternating-current (AC) power and easily feeds electric power to the first or second power path using electric power (direct-current (DC) power) of the power storage device. Further, by using the detection value from the first voltage sensor, the controller easily conducts the first and second inspections appropriately.

(Clause 3) In the charging system described in Clause 2, the switching device includes a first C contact relay and a second C contact relay. Each of the first C contact relay and the second C contact relay is configured to disconnect the power conversion circuit from one power path of the first power path and the second power path while connecting the power conversion circuit to the other power path of the first power path and the second power path.

The first and second C contact relays allow the switching device to appropriately switch between the first and second power paths.

(Clause 4) In the charging system described in Clause 3, the controller is configured to determine in the first inspection that the second C contact relay is welded, when the first voltage does not fall by controlling the switching device during application of a voltage from the first power path to the power conversion circuit such that the first C contact relay connects the power conversion circuit to the first power path and the second C contact relay connects the power conversion circuit to the second power path.

According to the above-described configuration, the first inspection allows the controller to easily grasp the state of the second C contact relay with accuracy. Specifically, when it is determined in the first inspection that the second C contact relay is welded, the second C contact relay is regarded as being welded on the first power path side.

(Clause 5) In the charging system described in Clause 4, the controller is configured to determine in the second inspection that the first C contact relay is welded, when the first voltage rises by controlling the switching device such that the first C contact relay connects the power conversion circuit to the second power path and the second C contact relay connects the power conversion circuit to the first power path.

According to the above-described configuration, the second inspection allows the controller to easily grasp the state of the first C contact relay with accuracy. Specifically, when it is determined in the second inspection that the first C contact relay is welded, the first C contact relay is regarded as being welded on the first power path side.

According to a third aspect of the present disclosure, a vehicle described below is provided.

(Clause 6) The vehicle includes the charging system described in any one of Clauses 2 to 5. The vehicle further includes: an inlet electrically connected to the first power path; and an outlet electrically connected to the second power path. The vehicle is configured to be able to execute AC charging in which AC power supplied from an outside of the vehicle to the inlet is converted into DC power by the charger, and the DC power is supplied to the power storage device. The controller is configured to start the first inspection in response to the AC charging being ended.

In AC charging, a voltage is applied between the first power line and the second power line constituting the first power path. In the vehicle, such a voltage is utilized to conduct an inspection when AC charging is ended. This eliminates the need to apply a voltage only for an inspection.

According to a fourth aspect of the present disclosure, a vehicle described below is provided.

(Clause 7) The vehicle includes the charging system described in Clause 5. The vehicle is configured to be able to travel using electric power output from the power storage device. The charger further includes: a second voltage sensor configured to detect a second voltage applied to the first power path; and a third voltage sensor configured to detect a third voltage applied to the second power path. The second voltage sensor and the third voltage sensor are configured to output a detection value of the second voltage and a detection value of the third voltage, respectively, to the controller. The controller is configured to conduct a third inspection. The third inspection includes: controlling the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device; determining that the first C contact relay is welded when the second voltage rises as a result of the controlling in the third inspection; and determining that the second C contact relay is welded when the third voltage rises as a result of the controlling in the third inspection. The controller is configured to further conduct a fourth inspection. The fourth inspection includes: in response to a determination in the third inspection that neither the first C contact relay nor the second C contact relay is welded, controlling the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device; determining that the second C contact relay is welded when the second voltage rises as a result of the controlling in the fourth inspection; and determining that the first C contact relay is welded when the third voltage rises as a result of the controlling in the fourth inspection. The controller is configured to start the third inspection at a start of traveling of the vehicle and/or during traveling of the vehicle.

In general, the inlet is used during parking. Further, while the vehicle is traveling (in particular, at the start of traveling), a user is more likely to refrain from using the outlet in order to suppress running-out of power in the power storage device. Thus, each of the inlet and the outlet is more likely to be in a disconnected state at the start of and during traveling of the vehicle. According to the above-described configuration, when the charger does not normally operate in the third or fourth inspection, the voltage applied to the inlet or the outlet is less likely to damage an external device connected to the inlet or the outlet (for example, a power feeding facility connected to the inlet or a power load connected to the outlet). Further, according to the above-described configuration, the third and fourth inspections allow the controller to easily grasp the states of the first and second C contact relays with accuracy.

(Clause 8) In the vehicle described in Clause 7, the controller is configured to prohibit first control for supplying electric power from the first power path to the power storage device in response to each of a determination in the third inspection that the second C contact relay is welded, and a determination in the fourth inspection that the first C contact relay is welded. The controller is configured to prohibit second control for supplying electric power from the power storage device to the second power path in response to each of a determination in the first inspection that the second C contact relay is welded, a determination in the second inspection that the first C contact relay is welded, a determination in the third inspection that the first C contact relay is welded, and a determination in the fourth inspection that the second C contact relay is welded.

When it is determined in the third inspection that the second C contact relay is welded, the second C contact relay is regarded as being welded on the second power path side. When it is determined in the fourth inspection that the first C contact relay is welded, the first C contact relay is regarded as being welded on the second power path side. Thus, by prohibiting the first control (the control for charging of the power storage device through the first power path) as described above, a control failure can be prevented in advance.

When it is determined in the first inspection that the second C contact relay is welded, the second C contact relay is regarded as being welded on the first power path side. When it is determined in the second inspection that the first C contact relay is welded, the first C contact relay is regarded as being welded on the first power path side. When it is determined in the third inspection that the first C contact relay is welded, the first C contact relay is regarded as being welded on the first power path side. When it is determined in the fourth inspection that the second C contact relay is welded, the second C contact relay is regarded as being welded on the first power path side. Thus, by prohibiting the second control (the control for discharging of the power storage device through the second power path) as described above, a control failure can be prevented in advance.

In this way, the first to fourth inspections allow the controller to easily grasp the states of the first and second C contact relays with accuracy. Thus, based on the grasped states, the controller can prohibit prescribed control (for example, control not suitable to the grasped states).

The foregoing and other objects, features, aspects, and advantages of the present disclosure will become apparent from the following detailed description of the present disclosure when taken in conjunction with the accompanying drawings.

### BRIEF DESCRIPTION OF THE DRAWINGS

Fig. 1 is a diagram showing a schematic configuration of a vehicle according to an embodiment of the present disclosure.
Fig. 2 is a flowchart illustrating first inspection control according to the embodiment of the present disclosure.
Fig. 3 is a diagram showing an example of a state of a charger determined as being normal in the control in Fig. 2.
Fig. 4 is a diagram showing a first example of the state of the charger determined as being faulty in the control in Fig. 2.
Fig. 5 is a diagram showing a second example of the state of the charger determined as being faulty in the control in Fig. 2.
Fig. 6 is a diagram showing a third example of the state of the charger determined as being faulty in the control in Fig. 2.
Fig. 7 is a diagram showing a fourth example of the state of the charger determined as being faulty in the control in Fig. 2.
Fig. 8 is a diagram showing a fifth example of the state of the charger determined as being faulty in the control in Fig. 2.
Fig. 9 is a flowchart illustrating second inspection control according to the embodiment of the present disclosure.
Fig. 10 is a diagram showing an example of a state of a charger determined as being normal in the control in Fig. 9.
Fig. 11 is a diagram showing a first example of the state of the charger determined as being faulty in the control in Fig. 9.
Fig. 12 is a diagram showing a second example of the state of the charger determined as being faulty in the control in Fig. 9.
Fig. 13 is a flowchart illustrating a control prohibition process according to the embodiment of the present disclosure.
Fig. 14 is a diagram showing a modification of a configuration of the vehicle shown in Fig. 1.

### DESCRIPTION OF THE PREFERRED EMBODIMENTS

Hereinafter, embodiments of the present disclosure will be described in detail with reference to the accompanying drawings. The same or corresponding portions in the drawings are denoted by the same reference characters, and the description thereof will not be repeated.

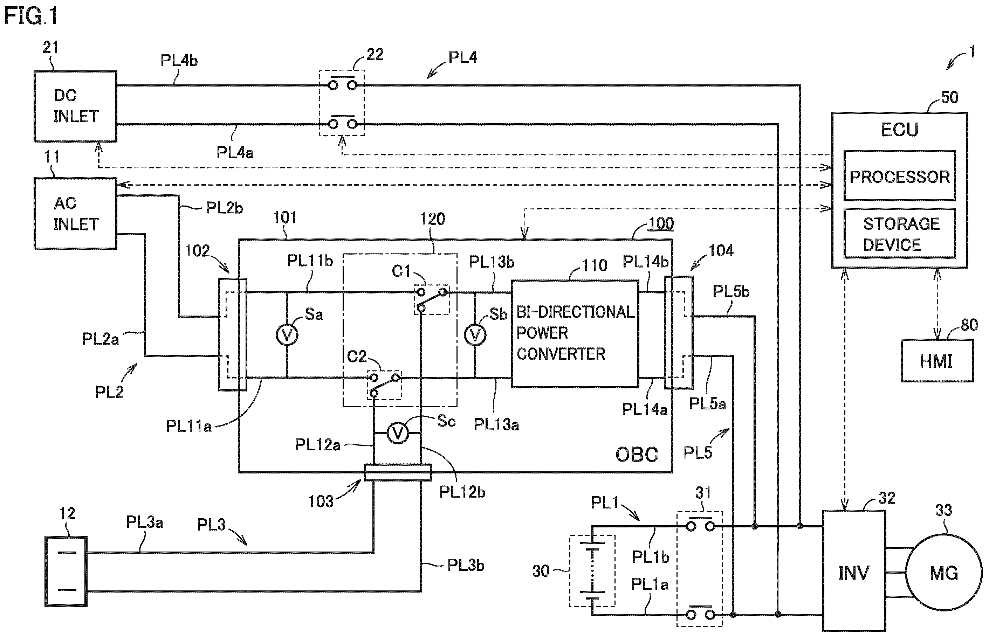

Fig. 1 is a diagram showing a configuration of a vehicle 1 according to the present embodiment. Referring to Fig. 1, vehicle 1 is, for example, a battery electric vehicle (BEV) not including an internal combustion engine. Without being limited to the above, vehicle 1 may be a plug-in hybrid electric vehicle (PHEV) including an internal combustion engine or may be another electrically powered vehicle (xEV).

Vehicle 1 includes an AC inlet 11, an outlet 12, a DC inlet 21, a relay 22, a charger 100, a battery 30, an SMR 31, an inverter 32, a motor generator (MG) 33, an ECU 50, and a human machine interface (HMI) 80. Charger 100 functions as an on-board charger (OBC). ECU 50 corresponds to an example of a "controller" according to the present disclosure. The "ECU" means an electronic control unit. The "SMR" means a system main relay.

Charger 100 includes a housing 101 and ports 102, 103, and 104 provided in housing 101. Charger 100 is configured to be electrically connectable to each of power paths PL1 to PL3 by ports 102, 103, and 104. Battery 30 is connected to power path PL1. Charger 100 is configured to be attachable to and detachable from each port. This facilitates replacement of charger 100.

A connector of power path PL2 connecting AC inlet 11 and charger 100 is connected to port 102. Power path PL2 includes a power line PL2a having the first polarity and a power line PL2b having the second polarity. Power path PL2 is electrically connected to each of AC inlet 11 and charger 100. A connector of power path PL3 connecting outlet 12 and charger 100 is connected to port 103. Power path PL3 includes a power line PL3a having the first polarity and a power line PL3b having the second polarity. Power path PL3 is electrically connected to each of outlet 12 and charger 100. A connector of a power path PL5 connecting power path PL1 and charger 100 is connected to port 104. Power path PL5 includes a power line PL5a having the first polarity and a power line PL5b having the second polarity. Power path PL5 is electrically connected to each of power path PL1 and charger 100. Power path PL1 includes a power line PL1a having the first polarity and a power line PL1b having the second polarity. Power path PL1 is electrically connected to each of battery 30 and power path PL5. Battery 30 outputs electric power for driving vehicle 1 to power path PL1. The first polarity is opposite in polarity to the second polarity. In the present embodiment, the first polarity is negative and the second polarity is positive. Without being limited to the above, the first polarity may be positive and the second polarity may be negative.

Power path PL1 extends from battery 30 to inverter 32. SMR 31 includes a pair of relays (for example, electromagnetic mechanical relays) provided on power lines PL1a and PL1b, and is configured to switch between connection and disconnection of power lines PL1a and PL1b. A power path PL4 extends from DC inlet 21 to power path PL1. Power path PL4 includes a power line PL4a having the first polarity and a power line PL4b having the second polarity. Power path PL4 is electrically connected to each of DC inlet 21 and power path PL1. Relay 22 includes a pair of relays (for example, electromagnetic mechanical relays) provided on power lines PL4a and PL4b, and is configured to switch between connection and disconnection of power lines PL4a and PL4b. Power line PL1a is connected to each of power lines PL4a and PL5a on the inverter 32 side with respect to SMR 31. Power line PL1b is connected to each of power lines PL4b and PL5b on the inverter 32 side with respect to SMR 31.

Vehicle 1 is configured to be able to travel using electric power output from battery 30. Specifically, MG 33 functions as a traveling motor, and inverter 32 functions as a drive circuit of MG 33. Electric power is supplied from battery 30 to inverter 32 through power lines PL1a and PL1b. Inverter 32 drives MG 33 using electric power output from battery 30. MG 33 converts electric power into torque to rotate driving wheels of vehicle 1. MG 33 charges battery 30 by performing regenerative power generation, for example, during deceleration of vehicle 1.

Vehicle 1 is configured to be able to perform AC charging in which AC power supplied from the outside of the vehicle to AC inlet 11 is converted by charger 100 into DC power that is then supplied to battery 30. Specifically, AC inlet 11 includes a connector lock device. When a connector of a charging cable of an AC power feeding facility external to the vehicle (the connector will be hereinafter referred to as an "AC connector") is connected to AC inlet 11, the connector lock device locks the AC connector (i.e., connector locking). Thereby, removal of the AC connector is suppressed. After the end of AC charging, locking of the AC connector is released (unlocked) by the connector lock device. This permits removal of the AC connector. Charger 100 includes a power conversion circuit 110 and a switching device 120. In the present embodiment, power conversion circuit 110 functions as a bi-directional power converter (for example, a bi-directional converter). Switching device 120 is provided at a confluence of power lines (power lines PL11a and PL11b) electrically connected to power path PL2, power lines (power lines PL12a and PL12b) electrically connected to power path PL3, and power lines (power lines PL13a and PL13b) electrically connected to power conversion circuit 110. Switching device 120 is configured to switch between connection and disconnection between power path PL2 and power conversion circuit 110. In the state in which switching device 120 selects power path PL2, power path PL2 is electrically connected to power conversion circuit 110, and power path PL3 is disconnected from power conversion circuit 110. AC charging is performed in this state.

For example, after the AC connector is connected to AC inlet 11 and connector locking is done, a prescribed inspection (an inspection before the start of power feeding) is conducted. If no abnormality is found in the inspection before the start of power feeding, AC power is supplied from the AC power feeding facility to AC inlet 11. Then, the AC power input from AC inlet 11 to port 102 is converted by power conversion circuit 110 into DC power having a prescribed voltage (for example, a voltage applicable to battery 30), and this converted DC power is then output to port 104. Thereby, DC power is output from charger 100 to battery 30, so that battery 30 is charged.

Vehicle 1 is configured to be able to perform DC charging in which the DC power supplied to vehicle 1 from the outside of vehicle 1 is supplied to battery 30 without passing through charger 100. Specifically, DC inlet 21 includes a connector lock device. When a connector of a charging cable of a DC power feeding facility external to the vehicle (this connector will be hereinafter referred to as a "DC connector") is connected to DC inlet 21, the DC connector is locked (connector locking) by the connector lock device. Thereby, removal of the DC connector is suppressed. After the end of DC charging, locking of the DC connector is released (unlocked) by the connector lock device. This permits removal of the DC connector.

For example, after the DC connector is connected to DC inlet 21 and connector locking is done, a prescribed inspection (an inspection before the start of power feeding) is performed. If no abnormality is found in the inspection before the start of power feeding, DC power is supplied from the DC power feeding facility to DC inlet 21. Then, when ECU 50 brings relay 22 into the connected state (the closed state), DC power is supplied from DC inlet 21 to battery 30 through power path PL4, so that battery 30 is charged.

Hereinafter, AC charging and DC charging may be collectively referred to as "external charging". The power feeding facility used in external charging may be electric vehicle supply equipment (EVSE) electrically connected to a power system.

Vehicle 1 is configured to be able to perform external power feeding in which DC power supplied from battery 30 to charger 100 is converted by charger 100 into AC power that is then supplied to outlet 12. Specifically, switching device 120 is configured to switch between connection and disconnection between power path PL3 and power conversion circuit 110. In the state in which switching device 120 selects power path PL3, power path PL3 is electrically connected to power conversion circuit 110, and power path PL2 is disconnected from power conversion circuit 110.

External power feeding is performed in this state. The DC power input from battery 30 to port 104 is converted by power conversion circuit 110 into AC power having a prescribed voltage (for example, a voltage applicable to outlet 12), and this converted AC power is then output to port 103. Thereby, AC power is output from charger 100 to outlet 12, to thereby allow use of outlet 12. By connecting the power load to outlet 12, the user can supply the electric power output from outlet 12 to the power load during external power feeding. Examples of the power load include lighting devices, air conditioning equipment, cooking appliances, refrigerators, and information processing units. Outlet 12 may be provided in the interior of vehicle 1. The number of outlets 12 is not limited to one and may be more than one. ECU 50 may perform external power feeding in response to a request from the user.

Relay 22, SMR 31, inverter 32, and charger 100 are controlled by ECU 50. SMR 31 is maintained in the connected state (the closed state) during each of traveling of vehicle 1, external charging, and external power feeding. ECU 50 brings relay 22 into the connected state when DC charging is started, and brings relay 22 into the disconnected state when DC charging ends.

Battery 30 applicable in this case can be a known power storage device for a vehicle (for example, a lithium ion secondary battery, a nickel-metal hydride secondary battery, or a sodium-ion secondary battery). The type of the secondary battery may be a liquid secondary battery or an all-solid secondary battery. A plurality of secondary batteries may constitute a battery assembly. An electric double layer capacitor may be adopted instead of the secondary battery. Battery 30 corresponds to an example of the "power storage device" according to the present disclosure.

In addition to power conversion circuit 110 and switching device 120 described above, charger 100 includes: power lines PL11a, PL12a, PL13a, and PL14a each having the first polarity; power lines PL11b, PL12b, PL13b, and PL14b each having the second polarity; and voltage sensors Sa, Sb, and Sc.

Switching device 120 is configured to switch between power paths PL2 and PL3. Specifically, switching device 120 includes a relay C2 having the first polarity and a relay C1 having the second polarity. Each of relays C1 and C2 is a C contact relay. As described below, each of relays C1 and C2 is configured to disconnect power conversion circuit 110 from one of power paths PL2 and PL3 while connecting power conversion circuit 110 to the other of power paths PL2 and PL3. In the present embodiment, relays C1 and C2 correspond to examples of the "first C contact relay" and the "second C contact relay", respectively, according to the present disclosure.

Power line PL11a is electrically connected to power line PL2a via port 102. Relay C2 has one end connected to power conversion circuit 110 through power line PL13a. Relay C2 has the other end connected to only one of power lines PL11a and PL12a that is selected by ECU 50. Power line PL12a is electrically connected to power line PL3a via port 103. Power conversion circuit 110 is electrically connected, through power line PL11a or PL12a connected by relay C2, to power line PL2a or PL3a of the corresponding power path. On the other hand, power conversion circuit 110 is disconnected from power line PL3a or PL2a of the power path that is not connected by relay C2. Hereinafter, connection of relay C2 to power line PL11a is referred to as a "C2 external connection". Connection of relay C2 to power line PL12a is referred to as a "C2 internal connection".

Power line PL11b is electrically connected to power line PL2b via port 102. Relay C1 has one end connected to power conversion circuit 110 through power line PL13b. Relay C1 has the other end connected to only one of power lines PL11b and PL12b that is selected by ECU 50. Power line PL12b is electrically connected to power line PL3b via port 103. Power conversion circuit 110 is electrically connected, through power line PL11b or PL12b connected by relay C1, to power line PL2b or PL3b of the corresponding power path. On the other hand, power conversion circuit 110 is disconnected from power line PL3b or PL2b of the power path that is not connected by relay C1. Hereinafter, connection of relay C1 to power line PL11b is referred to as a "C1 external connection". Connection of relay C1 to power line PL12b is referred to as a "C1 internal connection".

Power conversion circuit 110 is located between switching device 120 and port 104. Power conversion circuit 110 has one end connected to switching device 120 through power lines PL13a and PL13b. Power conversion circuit 110 has the other end connected to port 104 through power lines PL14a and PL14b. Power lines PL14a and PL14b are electrically connected to power lines PL5a and PL5b, respectively, via port 104.

When switching device 120 selects power path PL2, the "C1 external connection" and the "C2 external connection" are established. Thereby, power conversion circuit 110 is electrically connected to each of power lines PL2a and PL2b constituting power path PL2. Hereinafter, this state will be referred to as a "first switch state".

When switching device 120 selects power path PL3, the "C1 internal connection" and the "C2 internal connection" are established. Thereby, power conversion circuit 110 is electrically connected to each of power lines PL3a and PL3b constituting power path PL3. Hereinafter, this state will be referred to as a "second switch state".

Power conversion circuit 110 is configured to bi-directionally perform DC (direct current)/AC (alternating current) conversion. Power conversion circuit 110 may include an inverter and an isolation transformer. Power conversion circuit 110 is controlled to be set in one of: a stop state in which electric power is not output; a DC output state in which DC power is output to port 104; and an AC output state in which AC power is output to switching device 120. In AC charging, power conversion circuit 110 is set in the DC output state, and switching device 120 is set in the first switch state. Specifically, AC power supplied from AC inlet 11 to port 102 is input to power conversion circuit 110 through switching device 120 in the first switch state, and power conversion circuit 110 converts the AC power into DC power and outputs the converted DC power to battery 30. In external power feeding, power conversion circuit 110 is set in the AC output state and switching device 120 is set in the second switch state. Specifically, DC power supplied from battery 30 to port 104 is input to power conversion circuit 110. Then, power conversion circuit 110 converts the DC power into AC power and outputs the converted AC power to switching device 120. The AC power output from power conversion circuit 110 is supplied to outlet 12 through switching device 120 in the second switch state.

As described above, switching device 120 is configured to electrically connect one of power paths PL2 and PL3 to battery 30 (power conversion circuit 110). In the inspection for charger 100 (described later), however, switching device 120 is controlled to be set in the state other than the first switch state and the second switch state. In the inspection, detection values from voltage sensors Sa, Sb, and Sc described below are used.

Voltage sensor Sb is located between switching device 120 and power conversion circuit 110. Voltage sensor Sb detects a voltage applied between power lines PL13a and PL13b (this voltage will be hereinafter denoted as "Vb"). Vb denotes a first voltage applied between switching device 120 and power conversion circuit 110.

Voltage sensor Sa is located between port 102 and switching device 120. Voltage sensor Sa detects a voltage applied between power lines PL11a and PL11b (this voltage will be hereinafter denoted as "Va"). Va denotes a second voltage applied between power lines PL2a and PL2b on power path PL2.

Voltage sensor Sc is located between port 103 and switching device 120. Voltage sensor Sc detects a voltage applied between power lines PL12a and PL12b (this voltage will be hereinafter denoted as "Vc"). Vc denotes a third voltage applied between power lines PL3a and PL3b on power path PL3.

Voltage sensors Sa, Sb, and Sc are configured to output Va, Vb, and Vc, respectively, to ECU 50. Voltage sensors Sb, Sa, and Sc correspond to examples of the "first voltage sensor", the "second voltage sensor", and the "third voltage sensor", respectively, according to the present disclosure.

ECU 50 includes a processor and a storage device. The processor executes programs stored in the storage device to thereby execute various processes. However, various processes to be executed by ECU 50 may be executed only by hardware (electronic circuitry) without using software.

HMI 80 includes an input device and a notification device. Examples of the notification device include a display, a speaker, and a lamp. HMI 80 may include a touch panel display. Through HMI 80, the user may request ECU 50 to perform a process (for example, to start control related to traveling of vehicle 1, AC charging, DC charging, or external power feeding) or may input parameter values to ECU 50.

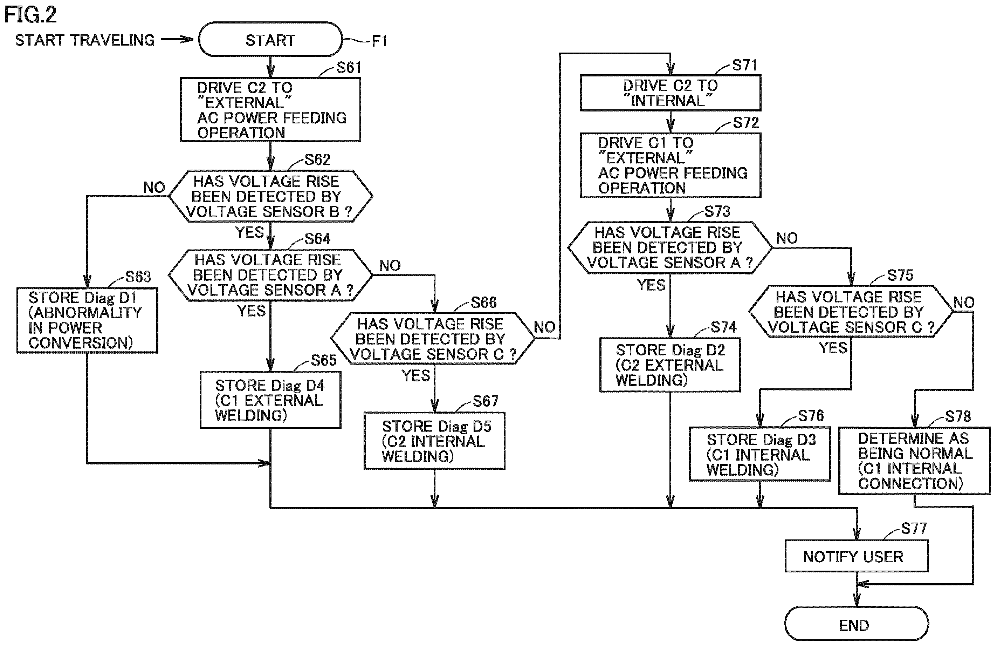

In the present embodiment, when vehicle 1 changes from a parking state to a traveling state, ECU 50 executes the inspection control shown in Fig. 2. Fig. 2 is a flowchart illustrating the first inspection control according to the present embodiment. "S" in the flowchart denotes a step.

For example, when the user requests vehicle 1 through HMI 80 to activate a control system (a vehicle system) of vehicle 1 while the vehicle system is stopped (including a sleep state), the vehicle system (including ECU 50) is activated. Then, the activated ECU 50 controls switching device 120 to be set in the second switch state. Further, when the user requests ECU 50 through HMI 80 to start traveling of vehicle 1, ECU 50 brings SMR 31 into the connected state such that the voltage of battery 30 is applied to inverter 32. This allows traveling of vehicle 1 by MG 33. Then, ECU 50 starts a process flow F1 shown in Fig. 2. At the start of process flow F1, if charger 100 normally operates, power conversion circuit 110 is in the stop state, and switching device 120 is in the second switch state (the state of the "C1 internal connection" and the "C2 internal connection").

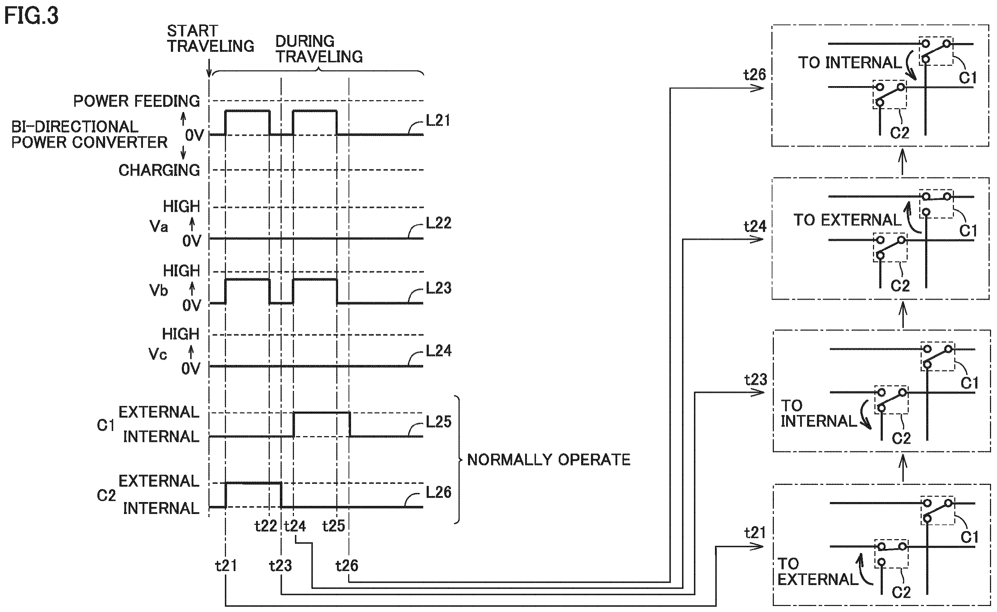

In process flow F1, in S61, ECU 50 drives relay C2 to the "C2 external connection" and instructs power conversion circuit 110 to perform an AC power feeding operation. Relay C2 and power conversion circuit 110 may be simultaneously controlled or may be sequentially controlled. ECU 50 transmits a control command to power conversion circuit 110 such that power conversion circuit 110 is set in the AC output state in a prescribed pattern (see Fig. 3 described later).

In S62, ECU 50 determines whether or not Vb has risen by the process in S61. When Vb has not risen (NO in S62), ECU 50 performs the processes in S63 and S77, and then, process flow F1 (inspection control) ends.

In S63, ECU 50 records diagnosis information. The diagnostic information is used in a process in which the vehicle itself diagnoses whether or not it normally operates (a self-diagnosis). Hereinafter, the diagnosis information is referred to as "Diag". In S63, ECU 50 causes the storage device to store a Diag D1. Diag D1 is information indicating that power conversion circuit 110 is faulty. In this way, ECU 50 determines that power conversion circuit 110 is faulty, when Vb has not risen even though ECU 50 controls charger 100 such that power conversion circuit 110 converts the DC power supplied from battery 30 into AC power and outputs the converted AC power to switching device 120. Such a configuration allows ECU 50 to easily grasp the state of the charging system with accuracy.

In subsequent S77, ECU 50 controls HMI 80 to notify the user about an abnormality. HMI 80 may notify the user about the abnormality by lighting a lamp. HMI 80 may display a message indicating that an abnormality has occurred in charger 100. HMI 80 may display a message to urge the user to replace the faulty charger 100. HMI 80 may display a map showing the location where charger 100 can be replaced (for example, the nearest dealer) and the route from the current position of vehicle 1 to the location, and may guide the user to the location.

When Vb has risen by the process in S61 (YES in S62), ECU 50 determines in S64 whether or not Va has risen by the process in S61. When Va has risen (YES in S64), ECU 50 performs the processes in S65 and S77. In S65, ECU 50 causes the storage device to store a Diag D4. Diag D4 is information indicating that relay C1 is welded in the state of the "C1 external connection". Then, the process in S77 described above is performed, and process flow F1 (inspection control) ends.

When Va has not risen by the process in S61 (NO in S64), ECU 50 determines in S66 whether or not Vc has risen by the process in S61. When Vc has risen (YES in S66), ECU 50 performs the processes in S67 and S77. In S67, ECU 50 causes the storage device to store a Diag D5. Diag D5 is information indicating that relay C2 is welded in the state of the "C2 internal connection". Then, the process in S77 described above is performed, and process flow F1 (inspection control) ends.

When neither Va nor Vc has risen by the process in S61 (NO in S66), ECU 50 drives relay C2 to the "C2 internal connection" in S71. In S72, ECU 50 subsequently drives relay C1 to the "C1 external connection", and instructs power conversion circuit 110 to perform the AC power feeding operation. Relay C1 and power conversion circuit 110 may be simultaneously controlled or may be sequentially controlled. In subsequent S73, ECU 50 determines whether or not Va has risen by the processes in S71 and S72. When Va has risen (YES in S73), ECU 50 performs the processes in S74 and S77. In S74, ECU 50 causes the storage device to store a Diag D2. Diag D2 is information indicating that relay C2 is welded in the state of the "C2 external connection". Then, the process in S77 described above is performed, and process flow F1 (inspection control) ends.

When Va has not risen by the processes in S71 and S72 (NO in S73), ECU 50 determines in S75 whether or not Vc has risen by the processes in S71 and S72. When Vc has risen (YES in S75), ECU 50 performs the processes in S76 and S77. In S76, ECU 50 causes the storage device to store a Diag D3. Diag D3 is information indicating that relay C1 is welded in the state of the "C1 internal connection". Then, the process in S77 described above is performed, and process flow F1 (inspection control) ends.

When neither Va nor Vc has risen by the processes in S71 and S72 (NO in S75), then in S78, ECU 50 determines that charger 100 normally operates, and establishes the "C1 internal connection". Thereby, the states of relays C1 and C2 return to those before the inspection.

In process flow F1, S61, S64, and S66 correspond to an example of the "third inspection", and S71 to S73 and S75 correspond to an example of the "fourth inspection". As described above, the third inspection is started when vehicle 1 starts traveling. When it is determined in the third inspection that charger 100 (switching device 120) is not faulty, the fourth inspection is conducted. Without being limited to the above, ECU 50 may start process flow F1 at the timing when the voltage applied to power path PL1 is stabilized (i.e., while vehicle 1 is traveling) after vehicle 1 starts traveling. For example, ECU 50 may start process flow F1 when a prescribed time period elapses since ECU 50 switches SMR 31 from the disconnected state to the connected state in order to start traveling of vehicle 1. ECU 50 may execute process flow F1 every time a prescribed time period elapses during traveling of vehicle 1.

Fig. 3 is a diagram for illustrating the state of charger 100 that is determined as being normal in process flow F1. In this case, "t" in the time chart denotes timing. A line L21 represents a pattern of the output voltage from power conversion circuit 110. Line L21 represents the state of power conversion circuit 110 set at each timing among the stop state (0 V), the AC output state (power feeding), and the DC output state (charging). Lines L22, L23, and L24 represent transitions of Va, Vb, and Vc, respectively. Lines L25 and L26 represent transitions of the states of connection (external connection/internal connection) of relays C1 and C2, respectively.

At the start of traveling of vehicle 1 shown in Fig. 3, process flow F1 shown in Fig. 2 is executed. By the process in S61, the control of the "C2 external connection" (see line L26) is executed at t21. Further, power conversion circuit 110 is controlled to be changed from the stop state to the AC output state at t21 and to be changed from the AC output state to the stop state at t22 (see line L21). During the time period from t21 to t22, Vb changes according to the pattern represented by line L21 (see line L23). Thus, power conversion circuit 110 is determined as being normal. During the time period from t21 to t22, ECU 50 controls switching device 120 such that power lines PL13a and PL13b are electrically connected to power paths PL2 and PL3, respectively, when a voltage is applied between power lines PL13a and PL13b by battery 30 (see lines L23, L25, and L26). In the example shown in Fig. 3, during the time period from t21 to t22, Va and Vc each do not change and remain at 0 V (see lines L22 and L24). Thus, it is determined in the third inspection that charger 100 (switching device 120) is not faulty.

Further, by the process in S71, the control of the "C2 internal connection" is executed at t23 (see line L26). By the process in S72, the control of the "C1 external connection" is executed at t24 (see line L25). Further, power conversion circuit 110 is controlled to be changed from the stop state to the AC output state at t24 and to be changed from the AC output state to the stop state at t25 (see line L21). During the time period from t24 to t25, ECU 50 controls switching device 120 such that power lines PL13a and PL13b are electrically connected to power paths PL3 and PL2, respectively, when a voltage is applied between power lines PL13a and PL13b by battery 30 (see lines L23, L25, and L26). In the example shown in Fig. 3, during the time period from t24 to t25, Va and Vc each do not change and remain at 0 V (see lines L22 and L24). Thus, it is determined also in the fourth inspection that charger 100 (switching device 120) is not faulty, and the "C1 internal connection" is established at t26.

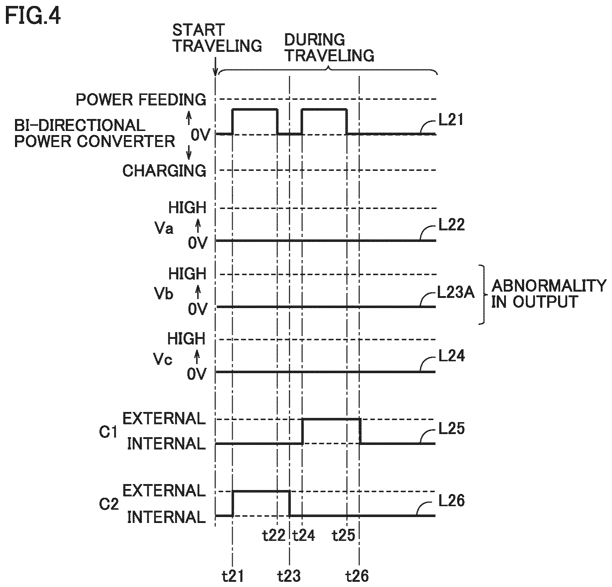

Fig. 4 is a diagram for illustrating the state of charger 100 at the time when Diag D1 is recorded in process flow F1. In the example shown in Fig. 4, as represented by a line L23A, Vb has not risen during the time period from t21 to t22 due to the fault in power conversion circuit 110. Thus, it is determined as NO in S62 in Fig. 2, and Diag D1 is recorded.

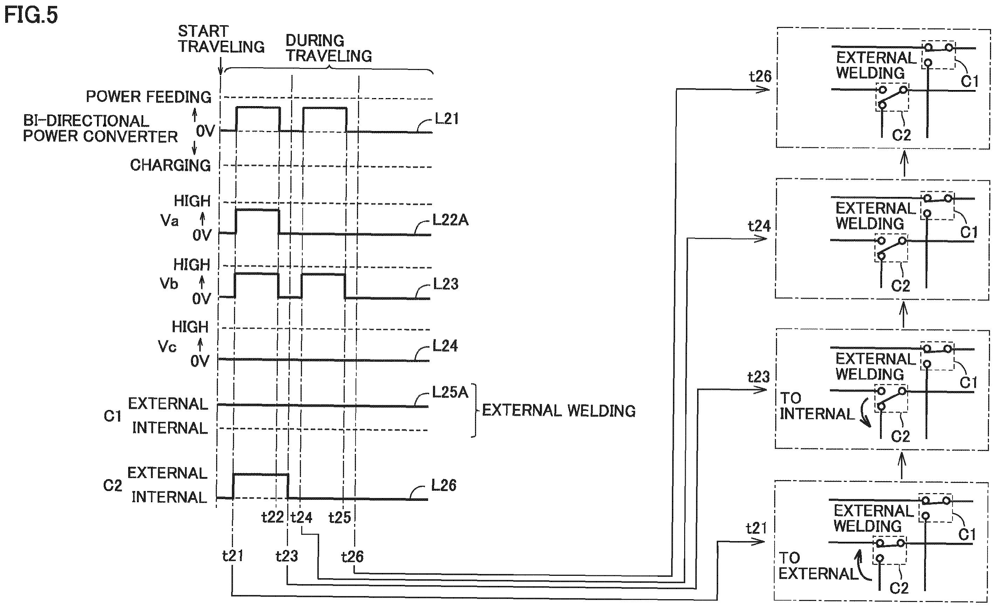

Fig. 5 is a diagram for illustrating the state of charger 100 at the time when Diag D4 is recorded in process flow F1. In the example shown in Fig. 5, as represented by a line L25A, relay C1 is welded in the state in which it is connected to power line PL11b (the state of the C1 external connection). Thus, Va rises during the time period from t21 to t22 (see a line L22A). Thereby, it is determined as YES in S64 in Fig. 2, and Diag D4 is recorded.

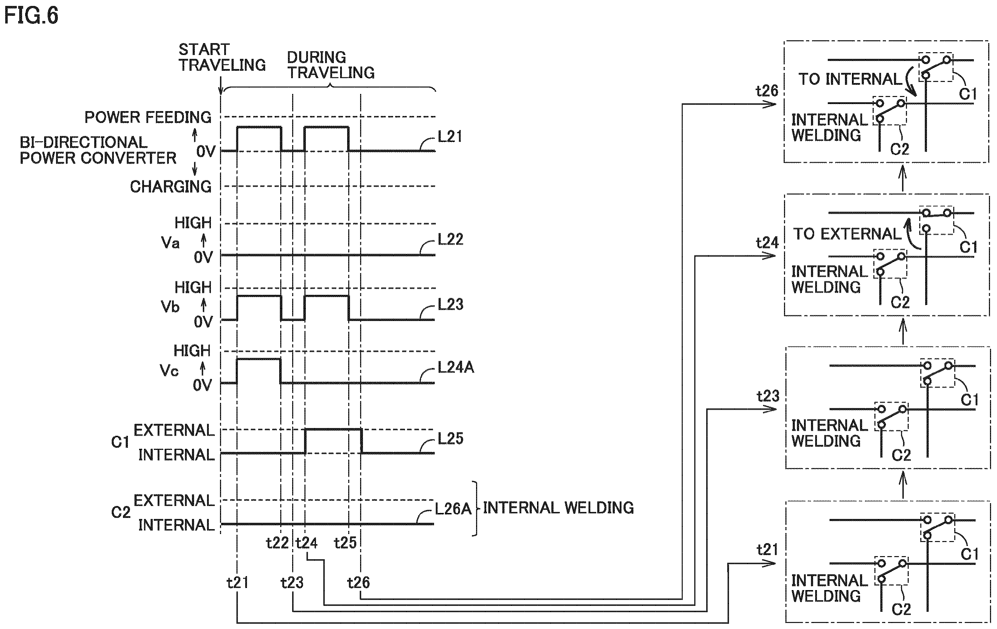

Fig. 6 is a diagram for illustrating the state of charger 100 at the time when Diag D5 is recorded in process flow F1. In the example shown in Fig. 6, as represented by a line L26A, relay C2 is welded in the state in which it is connected to power line PL12a (the state of the C2 internal connection). Thus, Vc rises during the time period from t21 to t22 (see a line L24A). Thereby, it is determined as YES in S66 in Fig. 2, and Diag D5 is recorded.

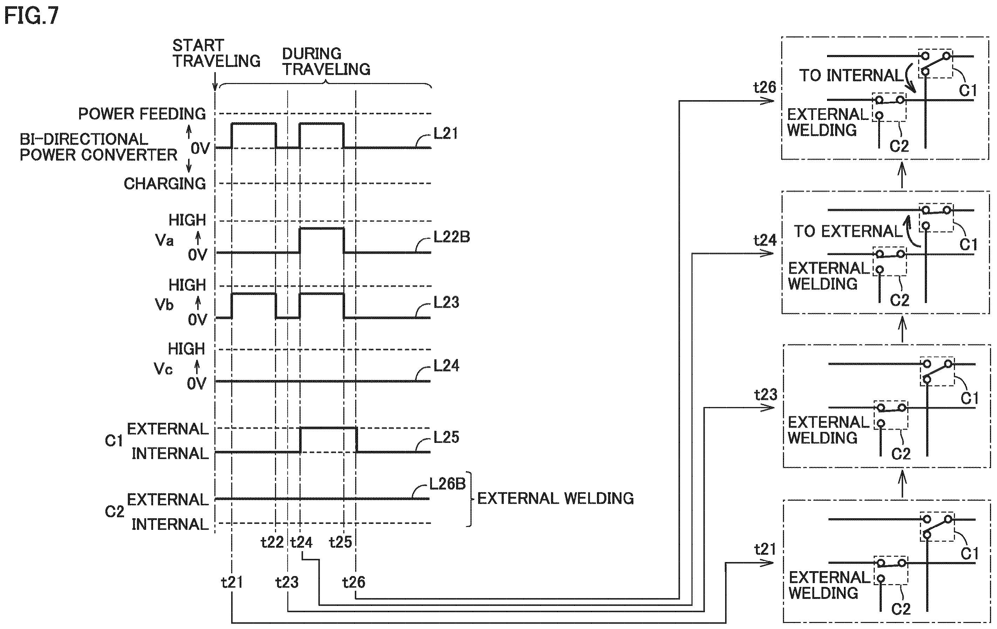

Fig. 7 is a diagram for illustrating the state of charger 100 at the time when Diag D2 is recorded in process flow F1. In the example shown in Fig. 7, as represented by a line L26B, relay C2 is welded in the state in which it is connected to power line PL11a (the state of the C2 external connection). Thus, Va rises during the time period from t24 to t25 (see a line L22B). Thereby, it is determined as YES in S73 in Fig. 2, and Diag D2 is recorded.

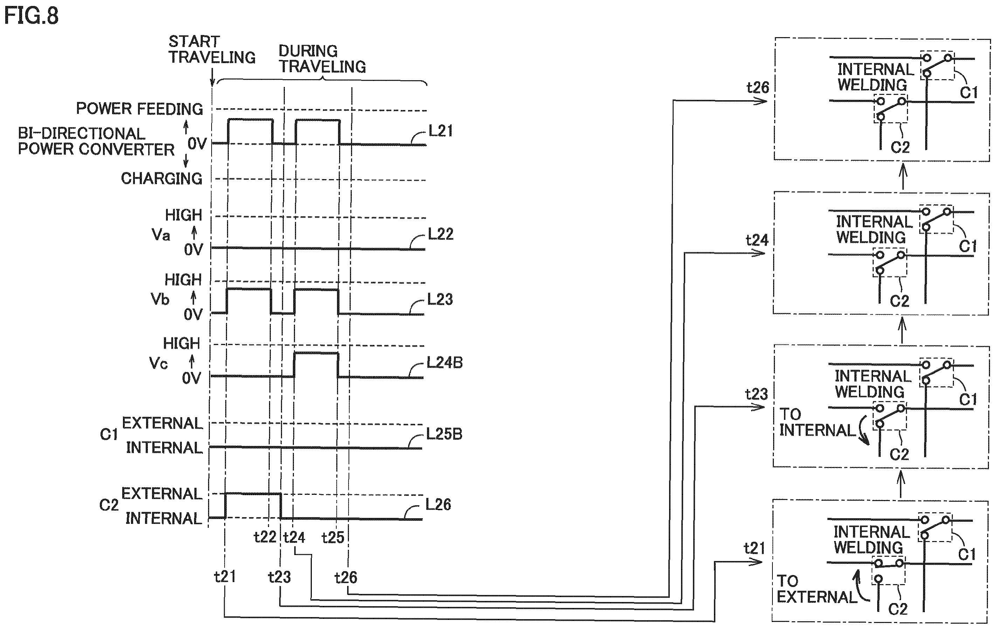

Fig. 8 is a diagram for illustrating the state of charger 100 at the time when Diag D3 is recorded in process flow F1. In the example shown in Fig. 8, as represented by a line L25B, relay C1 is welded in the state in which it is connected to power line PL12b (the state of the C1 internal connection). Thus, Vc rises during the time period from t24 to t25 (see a line L24B). Thereby, it is determined as YES in S75 in Fig. 2, and Diag D3 is recorded.

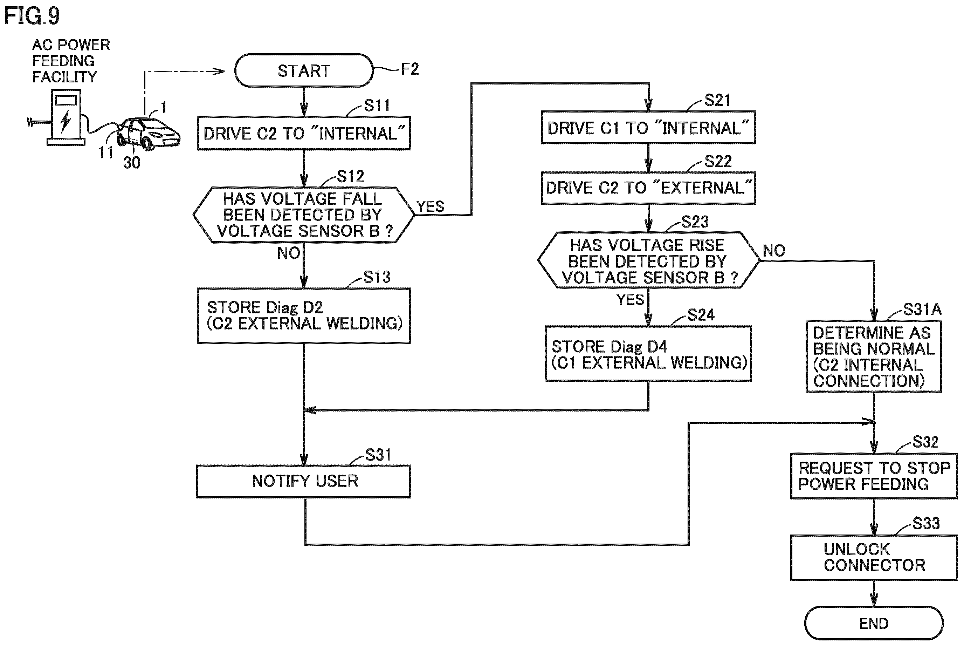

When AC charging is ended, ECU 50 further executes the inspection control shown in Fig. 9. Fig. 9 is a flowchart illustrating the second inspection control according to the present embodiment. In the present embodiment, when vehicle 1 changes from the traveling state into the parking state, ECU 50 controls SMR 31 to be set in the disconnected state, power conversion circuit 110 to be set in the stop state, and switching device 120 to be set in the first switch state. When the AC connector is connected to AC inlet 11 of vehicle 1 in the parking state and the AC connector is locked, ECU 50 brings SMR 31 into the connected state and executes the inspection before the start of power feeding. If no abnormality is found in the inspection before the start of power feeding, ECU 50 brings power conversion circuit 110 into the DC output state and starts AC charging.

During AC charging, ECU 50 determines whether or not an AC charging end condition has been satisfied. While the AC charging end condition is not satisfied, AC charging is continued. The AC charging end condition may be satisfied when the state of charge (SOC) of battery 30 reaches a target value by AC charging. The SOC represents a remaining amount of stored power, and expresses, for example, a ratio of a current amount of stored power to an amount of stored power in a fully charged state as 0% to 100%. Further, the AC charging end condition may be satisfied when a prescribed time period has elapsed since the start of AC charging. Further, the AC charging end condition may be satisfied in response to a request from the user to end the charging.

When the AC charging end condition is satisfied, ECU 50 brings power conversion circuit 110 into the stop state and starts a process flow F2 shown in Fig. 9. if charger 100 normally operates at the start of process flow F2, switching device 120 is in the first switch state (the state of the "C1 external connection" and the "C2 external connection"). Thus, a voltage is applied by the AC power feeding facility (through power path PL2) to power conversion circuit 110.

In S11, ECU 50 drives relay C2 to the "C2 internal connection". Specifically, ECU 50 transmits a control command for such driving. In subsequent S12, ECU 50 determines whether or not Vb has fallen by the process in S11. If Vb has not fallen (NO in S12), ECU 50 causes the storage device to store Diag D2 in S13, and then performs the processes in S31 to S33 described below.

In S31, ECU 50 controls HMI 80 to notify the user that an abnormality has been found. HMI 80 may notify the user about the abnormality by lighting a lamp. HMI 80 may display a message to abort the DC charging sequence due to occurrence of an abnormality in the charging system. HMI 80 may display a message to urge the user to replace the faulty charger 100. HMI 80 may display a map showing the location where charger 100 can be replaced (for example, the nearest dealer).

In subsequent S32, ECU 50 requests the AC power feeding facility to stop power feeding (stop charging). Thereby, supply of electric power from the AC power feeding facility to AC inlet 11 is stopped. Then, in S33, ECU 50 unlocks the AC connector. This allows the user to remove the AC connector from AC inlet 11. When the process in S33 is performed, process flow F2 ends.

When Vb has fallen by the process in S11 (YES in S12), ECU 50 drives relay C1 to the "C1 internal connection" in S21, and drives relay C2 to the "C2 external connection" in S22. Specifically, ECU 50 transmits a control command for driving each relay in this way. The relays may be simultaneously driven or may be sequentially driven (either relay may be driven earlier).

In subsequent S23, ECU 50 determines whether or not Vb has risen by the processes in S21 and S22. When Vb has risen (YES in S23), ECU 50 causes the storage device to store Diag D4 in S24, and then performs the processes in S31 to S33 described above. On the other hand, when Vb has not risen (NO in S23), then in S31A, ECU 50 determines that charger 100 normally operates, and establishes the "C2 internal connection". Thereby, switching device 120 is set in the second switch state. Subsequently, ECU 50 performs the processes in S32 and S33 described above. In either case, when the process in S33 is performed, process flow F2 ends.

In process flow F2, S11 and S12 correspond to an example of the "first inspection", and S21 to S23 correspond to an example of the "second inspection". As described above, the first inspection is started at the end of AC charging. When it is determined in the first inspection that charger 100 (switching device 120) is not faulty, the second inspection is conducted. After process flow F2 ends, ECU 50 may switch SMR 31 from the connected state to the disconnected state. Further, when it is determined in process flow F2 that one of relays C1 and C2 is welded in the state of the external connection, then after the end of process flow F2, ECU 50 may control the other of relays C1 and C2 to be set in the state of the internal connection.

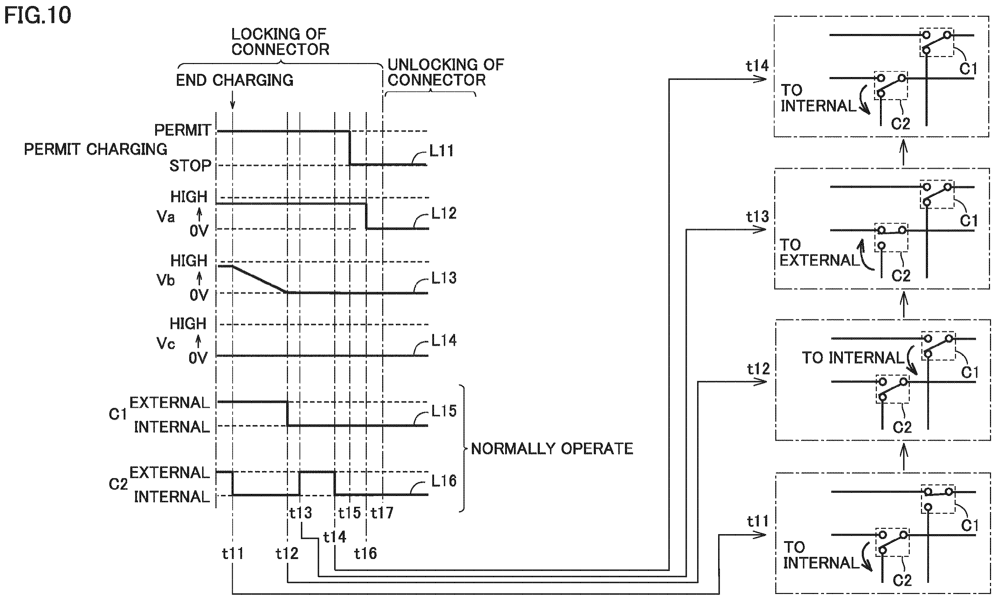

Fig. 10 is a diagram for illustrating the state of charger 100 that is determined as being normal in process flow F2. In Fig. 10, a line L11 represents a charging request signal (permission/stop) transmitted from vehicle 1 (ECU 50) to the AC power feeding facility. When the charging request signal indicates "permission", the AC power feeding facility feeds electric power to vehicle 1. When the charging request signal indicates "stop", the AC power feeding facility does not feed electric power to vehicle 1. Lines L12 to L16 in Fig. 10 correspond to lines L22 to L26 in Fig. 3 on one-to-one basis. However, each of lines L12 and L13 represents the charging power (electric power to battery 30) instead of the feeding power (electric power to the outside of the vehicle).

Referring to Fig. 10, process flow F2 shown in Fig. 9 is executed at the end of AC charging. At the start of process flow F2, a voltage is applied between power lines PL2a and PL2b constituting power path PL2. In such a state, by the process in S11, the control of the "C2 internal connection" (see line L16) is executed at t11. In this way, ECU 50 controls switching device 120 such that, during application of a voltage between power lines PL2a and PL2b, power lines PL2b and PL11b are electrically connected by relay C1 to power line PL13b (and thus battery 30) and power lines PL2a and PL11a are disconnected by relay C2 from power line PL13a (and thus battery 30) (see lines L12, L15, and L16). In the example shown in Fig. 10, by the process in S11, the voltage (Vb) falls (see line L13) that is applied on the side on which battery 30 is located with respect to switching device 120. Thus, it is determined in the first inspection that charger 100 (switching device 120) is not faulty.

Further, by the process in S21, the control of the "C1 internal connection" is executed at t12 (see line L15). By the process in S22, the control of the "C2 external connection" is executed at t13 (see line L16). In this way, when it is determined in the first inspection that charger 100 (switching device 120) is not faulty, ECU 50 controls switching device 120 such that power lines PL2a and PL11a are electrically connected by relay C2 to power line PL13a (and thus battery 30), and power lines PL2b and PL11b are disconnected by relay C1 from power line PL13b (and thus battery 30) (see lines L15 and L16). In the example shown in Fig. 10, even when the processes in S21 and S22 are performed, the voltage (Vb) has not risen (see line L13) that is applied on the side on which battery 30 is located with respect to switching device 120. Thus, it is determined also in the second inspection that charger 100 (switching device 120) is not faulty. Then, the "C2 internal connection" is established at t14 (see line L16), and the AC power feeding facility is requested to stop power feeding at t15 (see line L11). Thereby, supply of electric power from the AC power feeding facility to vehicle 1 is stopped at t16 (see line L12), and the connector is unlocked at t17.

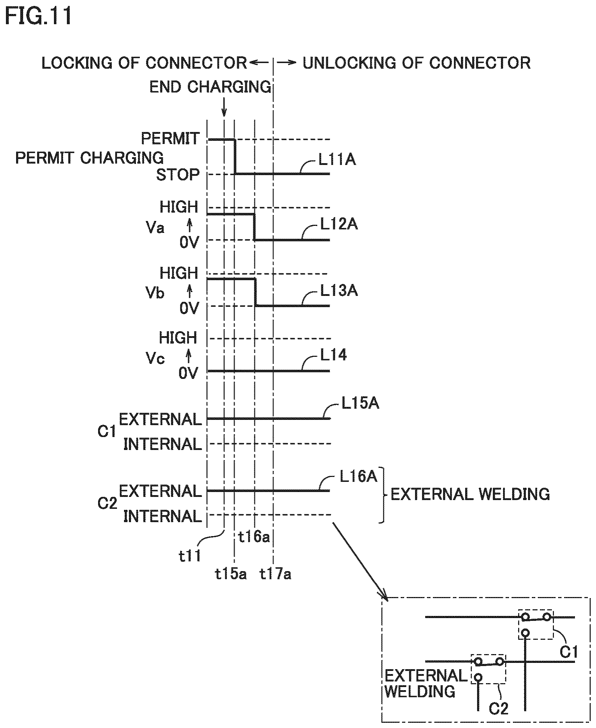

Fig. 11 is a diagram for illustrating the state of charger 100 at the time when Diag D2 is recorded in process flow F2. In the example shown in Fig. 11, as represented by a line L16A, relay C2 is welded in the state in which it is connected to power line PL11a (the state of the C2 external connection). Thus, the voltage (Vb) applied on the side on which battery 30 is located with respect to switching device 120 does not fall by the process in S11 (see a line L13A). In this case, AC charging is ended by a process (a process in the abnormal state) different from the process in the normal state. Specifically, the AC power feeding facility is requested to stop power feeding at t15a (see a line L11A) without performing the process in S21 (see a line L15A). Thereby, supply of electric power from the AC power feeding facility to vehicle 1 is stopped at t16a (see lines L12A and L13A), and the connector is unlocked at t17a.

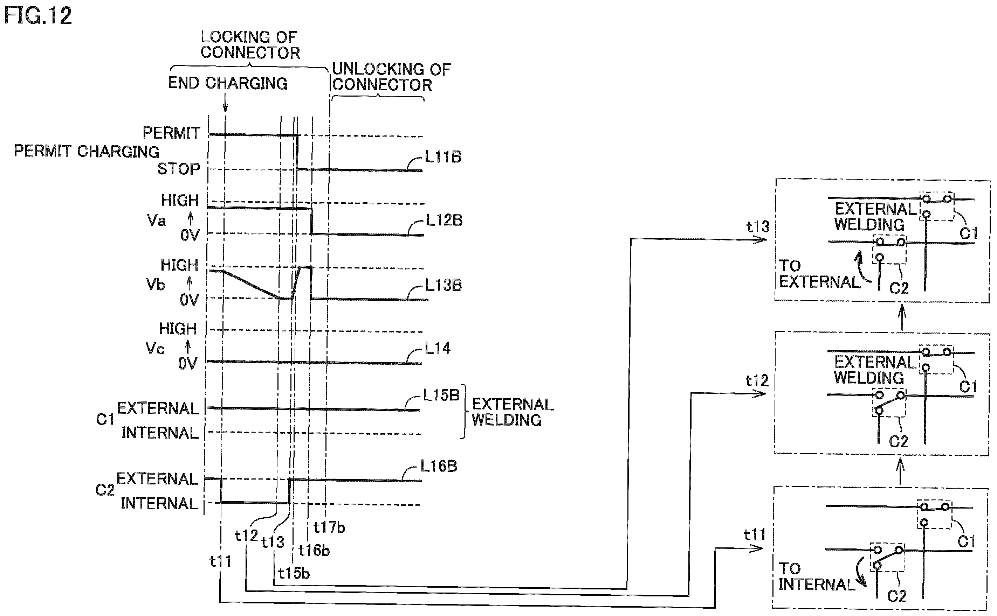

Fig. 12 is a diagram for illustrating the state of charger 100 at the time when Diag D4 is recorded in process flow F2. In the example shown in Fig. 12, as represented by a line L15B, relay C1 is welded in the state in which it is connected to power line PL11b (the state of the C1 external connection). Thus, when the "C2 external connection" is established at t13 (see a line L16B), the voltage (Vb) rises (see a line L13B) that is applied on the side on which battery 30 is located with respect to switching device 120. In this case, AC charging is ended by a process (a process in the abnormal state) different from the process in the normal state. Specifically, the AC power feeding facility is requested to stop power feeding at t15b (see a line L11B). Thereby, supply of electric power from the AC power feeding facility to vehicle 1 is stopped at t16b (see lines L12B and L13B), and the connector is unlocked at t17b.

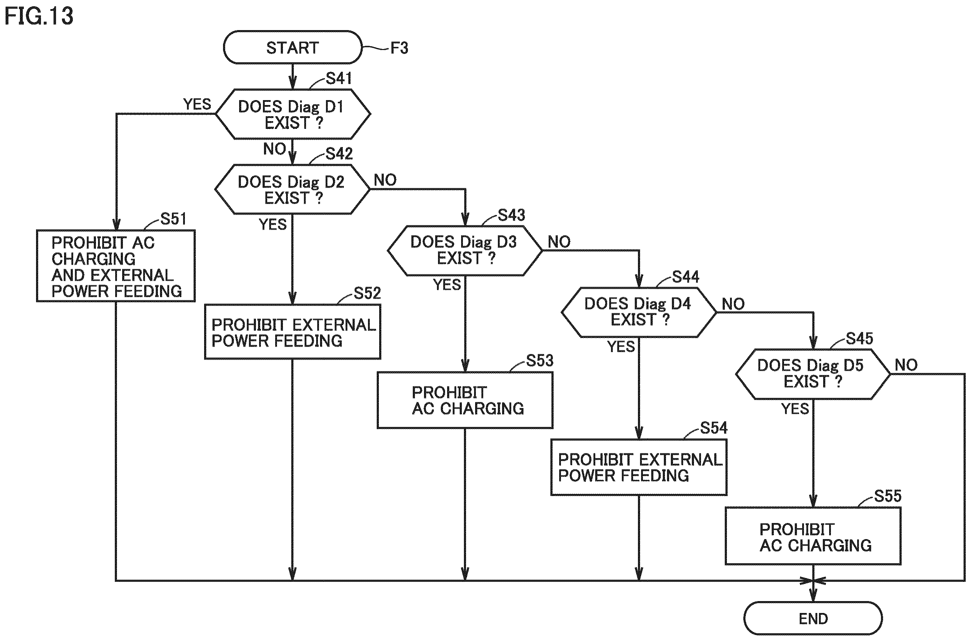

Fig. 13 is a flowchart illustrating a control prohibition process performed by ECU 50. Every time ECU 50 is activated, the activated ECU 50 executes a process flow F3 shown in Fig. 13. Further, process flow F3 is executed also when at least one of Diag D1 to Diag D5 is recorded in ECU 50 by process flow F1 or F2 described above. In the initial state, none of Diag D1 to Diag D5 is recorded in ECU 50. Further, even when at least one of Diag D1 to Diag D5 is recorded in the storage device of ECU 50, Diag D1 to Diag D5 in the storage device are deleted by replacing charger 100.

Referring to Fig. 13, ECU 50 determines in S41, S42, S43, S44, and S45 whether or not Diags D1, D2, D3, D4, and D5, respectively, exist in the storage device.

When Diag D1 exists (YES in S41), then in S51, the ECU 50's control related to AC charging and external power feeding is prohibited. For example, when the user requests ECU 50 through HMI 80 to perform AC charging or external power feeding, ECU 50 rejects the request. At this time, HMI 80 may issue a notification to urge the user to replace charger 100.

When Diag D1 does not exist (NO in S41) and Diag D2 or D4 exists (YES in S42 or S44), the ECU 50's control related to external power feeding is prohibited in S52 or S54. For example, when the user requests ECU 50 through HMI 80 to perform external power feeding, ECU 50 rejects the request. At this time, HMI 80 may issue a notification to urge the user to replace charger 100.

When Diag D1 does not exist (NO in S41) and Diag D3 or D5 exists (YES in S43 or S45), the ECU 50's control related to AC charging is prohibited in S53 or S55. For example, when the user requests ECU 50 through HMI 80 to perform AC charging, ECU 50 rejects the request. At this time, HMI 80 may issue a notification to urge the user to replace charger 100.

In the present embodiment, the start condition for AC charging includes the state in which none of Diags D1, D3, and D5 is stored in ECU 50. Further, the start condition for external power feeding includes the state in which none of Diags D1, D2, and D4 is stored in ECU 50. Thus, when any one of Diags D1, D3, and D5 is stored in ECU 50, it is determined in any one of S51, S53, and S55 that the start condition for AC charging is not satisfied, and then, AC charging is prohibited. Further, when any one of Diags D1, D2, and D4 is stored in ECU 50, it is determined in any one of S51, S52, and S54 that the start condition for external power feeding is not satisfied, and then, external power feeding is prohibited. Since Diag D1 to Diag D5 are deleted upon replacement of charger 100, the processes in S51 to S55 are not performed. Thus, the start condition for each of AC charging and external power feeding can be satisfied. For example, when other requirements (for example, completion of locking of the AC connector and determination as being normal in a cable check) in the start condition for AC charging are satisfied, AC charging is started. Without being limited to the above, when any one of Diag D2 to Diag D5 is stored in ECU 50, both AC charging and external power feeding may be prohibited.

As described above, ECU 50 (the controller) according to the present embodiment is configured to control charger 100 electrically connected to each of power path PL2 (the first power path), power path PL3 (the second power path), and battery 30. ECU 50 controls charger 100 such that, during AC charging, battery 30 and power path PL2 are electrically connected via charger 100, and charger 100 charges battery 30 with electric power supplied from power path PL2. ECU 50 controls charger 100 such that, during external power feeding, battery 30 and power path PL3 are electrically connected via charger 100, and charger 100 supplies electric power to power path PL3 using electric power supplied from battery 30. ECU 50 executes process flows F1 to F3 (Figs. 2, 9, and 13). In the present embodiment, each process is performed by one or more processors executing programs stored in one or more memories. However, these processes may be executed only by hardware (electronic circuitry) without using software.

Specifically, by the processes in S11 and S12 in process flow F2 (Fig. 9), ECU 50 controls switching device 120 such that, during application of a voltage between power lines PL2a and PL2b constituting power path PL2, power line PL2b (the first power line) is electrically connected to battery 30 and power line PL2a (the second power line) is disconnected from battery 30, and determines whether or not switching device 120 is faulty based on the voltage (Vb) applied on the side on which battery 30 is located with respect to switching device 120. Then, when it is determined in S12 that switching device 120 is not faulty, then, by the processes in S21 to S23 in process flow F2 (Fig. 9), ECU 50 controls switching device 120 such that power line PL2a (the second power line) is electrically connected to battery 30 and power line PL2b (the first power line) is disconnected from battery 30, and determines whether or not switching device 120 is faulty based on the voltage (Vb) applied on the side on which battery 30 is located with respect to switching device 120. According to such a configuration, the state of the charging system (in particular, whether or not switching device 120 is faulty) can be accurately grasped.

In process flow F2 shown in Fig. 9, ECU 50 controls switching device 120 such that, during application of a voltage from power path PL2 to power conversion circuit 110, relay C1 connects power conversion circuit 110 to power path PL2 and relay C2 connects power conversion circuit 110 to power path PL3 (S11). Then, when Vb has not fallen by such control, ECU 50 determines that relay C2 is welded (S12, 13). Such an inspection allows ECU 50 to easily grasp the state of relay C2 with accuracy.

When it is determined in S12 in Fig. 9 that switching device 120 is not faulty, ECU 50 controls switching device 120 such that relay C1 connects power conversion circuit 110 to power path PL3 and relay C2 connects power conversion circuit 110 to power path PL2 (S21, S22). Then, when Vb has risen by such control, ECU 50 determines that relay C1 is welded (S23, S24). Such an inspection allows ECU 50 to easily grasp the state of relay C1 with accuracy.

Further, ECU 50 starts process flow F1 shown in Fig. 2 at the start of traveling of vehicle 1 and/or during traveling of vehicle 1. In process flow F1, ECU 50 controls charger 100 such that relay C1 connects power conversion circuit 110 to power path PL3, relay C2 connects power conversion circuit 110 to power path PL2, and power conversion circuit 110 converts DC power supplied from battery 30 into AC power and outputs the converted AC power to switching device 120 (S61). In such control, when Va has risen, ECU 50 determines that relay C1 is welded (S64, S65), and when Vc has risen, ECU 50 determines that relay C2 is welded (S66, S67). When it is determined that both relays C1 and C2 are not welded, ECU 50 controls charger 100 such that relay C1 connects power conversion circuit 110 to power path PL2, relay C2 connects power conversion circuit 110 to power path PL3, and power conversion circuit 110 converts DC power supplied from battery 30 into AC power and outputs the converted AC power to switching device 120 (S71, S72). In such control, when Va has risen, ECU 50 determines that relay C2 is welded (S73, S74), and when Vc has risen, ECU 50 determines that relay C1 is welded (S75, S76). Such an inspection allows ECU 50 to easily grasp the states of relays C1 and C2 with accuracy.

In the present embodiment, the first control (for example, AC charging control) for supplying electric power from power path PL2 to battery 30 is prohibited in S55 in Fig. 13 when relay C2 is determined as being welded in S66 and S67 (the third inspection) in Fig. 2, or prohibited in S53 in Fig. 13 when relay C1 is determined as being welded in S75 and S76 (the fourth inspection) in Fig. 2. Further, the second control (for example, external power feeding control) for supplying electric power from battery 30 to power path PL3 is prohibited in S52 in Fig. 13 when relay C2 is determined as being welded in S12 and S13 (the first inspection) in Fig. 9, or prohibited in S54 in Fig. 13 when relay C1 is determined as being welded in S23 and S24 (the second inspection) in Fig. 9. Further, the second control (for example, external power feeding control) for supplying electric power from battery 30 to power path PL3 is prohibited in S54 in Fig. 13 when relay C1 is determined as being welded in S64 and S65 (the third inspection) in Fig. 2, or prohibited in S52 in Fig. 13 when relay C2 is determined as being welded in S73 and S74 (the fourth inspection) in Fig. 2. According to such a control prohibition process, a control failure can be prevented in advance.

In vehicle 1 according to the above-described embodiment, AC inlet 11 is used only for charging. Without being limited to the above, however, AC inlet 11 may be used for external power feeding (power feeding from a power storage device mounted in vehicle 1 to the outside of the vehicle). Vehicle 1 may be configured to output the electric power stored in battery 30 to the outside of the vehicle through one of AC inlet 11 and outlet 12 that is selected by switching device 120. In such a configuration, when at least one of relays C1 and C2 is welded in the state of the internal connection, AC inlet 11 (power path PL2) cannot be selected by switching device 120. Further, when at least one of relays C1 and C2 is welded in the state of the external connection, outlet 12 (power path PL3) cannot be selected by switching device 120. Thus, when at least one of relays C1 and C2 is welded in the state of the internal connection, ECU 50 may prohibit external power feeding using AC inlet 11. Further, when at least one of relays C1 and C2 is welded in the state of the external connection, ECU 50 may prohibit external power feeding using outlet 12.

The configuration of the vehicle is not limited to the configuration shown in Fig. 1. For example, the configuration of the switching device may be modified. The switching device may include three or more C contact relays, and may include an A contact relay and/or a B contact relay. Further, the circuit configuration shown in Fig. 1 may be modified.

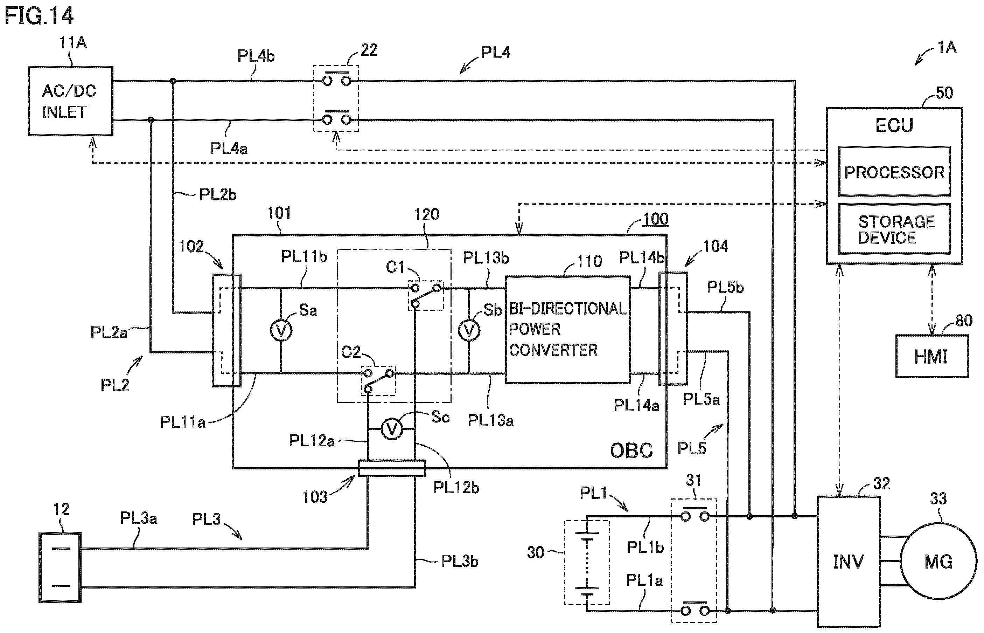

Fig. 14 is a diagram showing a modification of the configuration of the vehicle shown in Fig. 1. Referring to Fig. 14, in a vehicle 1A according to the modification, an AC/DC inlet 11A is provided instead of AC inlet 11 and DC inlet 21. AC/DC inlet 11A is an inlet common to AC charging and DC charging. Both the AC connector and the DC connector are connectable to AC/DC inlet 11A. AC/DC inlet 11A is electrically connected to each of port 102 of charger 100 and power path PL1. Specifically, power path PL2 connected to port 102 is connected to somewhere in power path PL4 (specifically, to a portion in power path PL4 that is close to AC/DC inlet 11A with respect to relay 22). During AC charging, ECU 50 controls charger 100 while maintaining relay 22 in the disconnected state. During DC charging, ECU 50 causes switching device 120 to select power path PL3 and maintains relay 22 in the connected state. When at least one of relays C1 and C2 is welded in the state of the external connection, power path PL3 cannot be selected by switching device 120. Thus, ECU 50 may prohibit DC charging when at least one of relays C1 and C2 is welded in the state of the external connection.

The object to which the controller is applied is not limited to a power storage system mounted in the vehicle, but the controller is applicable to any object. The controller may be applicable to a power storage system used in vehicles other than automobiles (such as railroad vehicles, ships, airplanes, and amphibious machines), movable machines (such as agricultural machines and architectural machines), unmanned movable bodies (such as automated guided vehicles (AGV), walking robots, security robots, flight drones, underwater drones, robot cleaners, and space probes), wearable robots (for example, nursing-care robots), stationary robots (for example, industrial robots), or buildings (such as houses and factories).

Process flows F1, F2, and F3 shown in Figs. 2, 9, and 13, respectively, can be modified as appropriate. For example, depending on the purpose, the order of processes may be changed or unnecessary steps may be omitted. Further, the details of any of the processes may be changed. For example, the inspection of power conversion circuit 110 (S62, S63 in Fig. 2) may be omitted.

Although the embodiments of the present disclosure have been described, it should be understood that the embodiments disclosed herein are illustrative and not restrictive in every respect. The scope of the present disclosure is defined by the terms of the claims, and is intended to include any modifications within the scope and meaning equivalent to the terms of the claims.

## Claims

1. A controller (50) that controls a charger (100) configured to be electrically connectable to each of a first power path (PL2), a second power path (PL3), and a power storage device (30), wherein
the charger includes a switching device (120) configured to electrically connect one of the first power path and the second power path to the power storage device,
the controller is configured to control the charger to charge the power storage device with electric power supplied from the first power path while the power storage device and the first power path are electrically connected via the charger,
the controller is configured to control the charger to supply electric power to the second power path using electric power supplied from the power storage device while the power storage device and the second power path are electrically connected via the charger,
the controller is configured to conduct a first inspection and a second inspection,
the first inspection includes:
controlling the switching device such that, during application of a voltage between a first power line (PL2b) and a second power line (PL2a) constituting the first power path, the first power line is electrically connected to the power storage device and the second power line is disconnected from the power storage device; and
determining whether or not the switching device is faulty based on a voltage applied on a side on which the power storage device is located with respect to the switching device, and
the second inspection includes:
in response to a determination in the first inspection that the switching device is not faulty,
controlling the switching device such that the second power line is electrically connected to the power storage device and the first power line is disconnected from the power storage device; and
determining whether or not the switching device is faulty based on the voltage applied on the side on which the power storage device is located with respect to the switching device.

2. A charging system comprising:
the controller (50) according to claim 1; and
the charger (100) configured to be controlled by the controller (50), wherein
the charger (100) includes
a power conversion circuit (110) located between the switching device (120) and the power storage device (30), and
a first voltage sensor (Sb) configured to detect a first voltage (Vb) applied between the switching device (120) and the power conversion circuit (110),
the power conversion circuit is configured to convert DC power supplied from the power storage device into AC power and output the AC power to the switching device,
the power conversion circuit is configured to convert AC power supplied from the first power path (PL2) into DC power and output the DC power to the power storage device, and
the first voltage sensor is configured to output a detection value of the first voltage to the controller.

3. The charging system according to claim 2, wherein
the switching device includes a first C contact relay (C1) and a second C contact relay (C2), and
each of the first C contact relay and the second C contact relay is configured to disconnect the power conversion circuit from one power path of the first power path (PL2) and the second power path (PL3) while connecting the power conversion circuit to the other power path of the first power path (PL2) and the second power path (PL3).

4. The charging system according to claim 3, wherein the controller is configured to determine (S12, S13) in the first inspection that the second C contact relay is welded, when the first voltage does not fall by controlling (S11) the switching device during application of a voltage from the first power path to the power conversion circuit such that the first C contact relay connects the power conversion circuit to the first power path and the second C contact relay connects the power conversion circuit to the second power path.

5. The charging system according to claim 4, wherein the controller is configured to determine (S23, S24) in the second inspection that the first C contact relay is welded, when the first voltage rises by controlling (S21, S22) the switching device such that the first C contact relay connects the power conversion circuit to the second power path and the second C contact relay connects the power conversion circuit to the first power path.

6. A vehicle (1) comprising the charging system according to any one of claims 2 to 5, the vehicle comprising:
an inlet (11) electrically connected to the first power path (PL2); and
an outlet (12) electrically connected to the second power path (PL3), wherein
the vehicle is configured to be able to execute AC charging in which AC power supplied from an outside of the vehicle to the inlet is converted into DC power by the charger (100), and the DC power is supplied to the power storage device (30), and
the controller (50) is configured to start the first inspection in response to the AC charging being ended.

7. A vehicle (1) comprising the charging system according to claim 5,
the vehicle being configured to be able to travel using electric power output from the power storage device (30), wherein
the charger (100) includes
a second voltage sensor (Sa) configured to detect a second voltage (Va) applied to the first power path (PL2), and
a third voltage sensor (Sc) configured to detect a third voltage (Vc) applied to the second power path (PL3),
the second voltage sensor and the third voltage sensor are configured to output a detection value of the second voltage and a detection value of the third voltage, respectively, to the controller (50),
the controller is configured to conduct a third inspection,
the third inspection includes:
controlling (S61) the charger such that the first C contact relay connects the power conversion circuit to the second power path, the second C contact relay connects the power conversion circuit to the first power path, and the power conversion circuit converts DC power supplied from the power storage device into AC power and outputs the AC power to the switching device;
determining (S64, S65) that the first C contact relay is welded when the second voltage rises as a result of the controlling (S61) in the third inspection; and
determining (S66, S67) that the second C contact relay is welded when the third voltage rises as a result of the controlling (S61) in the third inspection,
the controller is configured to further conduct a fourth inspection,
the fourth inspection includes:
in response to a determination in the third inspection that neither the first C contact relay nor the second C contact relay is welded,
controlling (S71, S72) the charger such that the first C contact relay connects the power conversion circuit to the first power path, the second C contact relay connects the power conversion circuit to the second power path, and the power conversion circuit converts DC power supplied from the power storage device into AC power and outputs the AC power to the switching device;
determining (S73, S74) that the second C contact relay is welded when the second voltage rises as a result of the controlling (S71, S72) in the fourth inspection; and
determining (S75, S76) that the first C contact relay is welded when the third voltage rises as a result of the controlling (S71, S72) in the fourth inspection, and
the controller is configured to start the third inspection at a start of traveling of the vehicle and/or during traveling of the vehicle.

8. The vehicle according to claim 7, wherein
the controller is configured to prohibit (S53, S55) first control for supplying electric power from the first power path to the power storage device in response to each of a determination (S67) in the third inspection that the second C contact relay is welded, and a determination (S76) in the fourth inspection that the first C contact relay is welded, and
the controller is configured to prohibit (S52, S54) second control for supplying electric power from the power storage device to the second power path in response to each of a determination (S13) in the first inspection that the second C contact relay is welded, a determination (S24) in the second inspection that the first C contact relay is welded, a determination (S65) in the third inspection that the first C contact relay is welded, and a determination (S74) in the fourth inspection that the second C contact relay is welded.
